# EUROPEAN PATENT SPECIFICATION

(11) **EP 1 797 017 B1**
(45) Date of publication and mention of the grant of the patent: **24.11.2010**
(21) Application number: 05802370.6
(22) Date of filing: 04.10.2005
(51) Int. Cl.: C03C 17/38, C03C 17/42, B32B 17/10, B65D 85/48, B65G 49/06

(54) **THIN FILM COATING AND TEMPORARY PROTECTION TECHNOLOGY, INSULATING GLAZING UNITS, AND ASSOCIATED METHODS**
DÜNNFILMBESCHICHTUNG UND TECHNOLOGIE ZUM ZEITWEILIGEN SCHUTZ, ISOLIERVERGLASUNGSEINHEITEN UND DAZUGEHÖRIGE VERFAHREN
REVETEMENT EN COUCHE MINCE ET TECHNOLOGIE DE PROTECTION TEMPORAIRE, UNITES DE VITRAGE ISOLANT ET PROCEDES ASSOCIES

(30) Priority: 04.10.2004 US 615711 P
(43) Date of publication of application: 20.06.2007
(73) Proprietor: Cardinal CG Company, Eden Prairie, MN 55344-4235 (US)
(72) Inventor: KRISKO, Annette, Sauk City, WI 53583 (US); GROMMESH, Robert, St. Louis Park, MN 55426 (US)
(74) Representative: Persson, Albin
(86) International application number: PCT/US2005/035836
(87) International publication number: WO 2006/041924

(56) References cited:
- WO-A-01/02496
- WO-A-02/22516
- WO-A-97/15499
- WO-A-2006/036605
- US-A1- 2005 210 921

## Description

### Field of the Invention

The present invention relates in some embodiments to sputter deposition techniques for applying thin film and thereafter applying over the sputtered film a temporary protective film. The thin film can be applied by sputtering a target in a gaseous sputtering atmosphere containing an oxidizing gas and/or an inert gas. The invention in some embodiments relates to an insulating glazing unit or a monolithic pane having a thin film coating, deposited for example by sputtering, on at least one major surface, the thin film coating carrying a temporary protective film. The invention also provides embodiments involving high efficiency methods for producing such products.

### Background of the Invention

In the coated glass industry, it is common to apply one or more thin films onto glass to impart desired properties in the coated glass. For example, in manufacturing glass for window and door applications, it is advantageous to apply infrared-reflective coatings as well as one or more other coatings that provide photoactivity.

Insofar as infrared-reflective coatings are concerned, these coatings help provide comfortable interior climates within homes and other buildings. Human beings have a relatively narrow temperature range in which they are comfortable. Unfortunately, infrared (IR) energy from the sun entering a room through a window can quickly raise the temperature in the room to an uncomfortable level. Infrared-reflective coatings have been developed, inter alia, to prevent heat spikes in a room by reflecting some of the incident infrared energy. These coatings also help keep a room warm in the winter by reflecting back into the room some of the infrared energy that would otherwise escape through windows. Thus, infrared-reflective coatings help establish a comfortable living environment while reducing heating and air conditioning costs.

Insofar as photocatalytic coatings are concerned, these coatings have been developed to provide low-maintenance properties for windows and other glazings. Some photocatalytic coatings can reduce the need for, or the effort involved in, cleaning the glass of windows, doors, skylights, and the like. Given the time and effort spent by the average homeowner on window cleaning, the advantages of a low-maintenance window are apparent. Moreover, when one considers the extensive measures and expense involved in cleaning the glass exteriors of modem skyscrapers, the upside of low-maintenance glass can be acutely appreciated.

Photocatalytic coatings can be designed to have a self-cleaning effect. For example, thick photocatalytic coatings tend to have a significant ability to chemically degrade organic contaminants. Such coatings commonly comprise a relatively thick layer of titanium dioxide. Thick titanium dioxide, unfortunately, produces relatively high levels of visible reflectance. It has been discovered that this high visible reflection actually exaggerates the appearance of dirt on a window, resulting in a window that looks particularly dirty. This, of course, is not desirable, as the very purpose of a photocatalytic coating is to provide a cleaner window. Furthermore, thick titanium dioxide films tend to produce more reflected color than is commonly desired. Moreover, when a substrate is provided with both a photocatalytic coating and a low-emissivity coating, the reflected color tends to be less than ideal.

Photocatalytic coatings are commonly intended to be exposed to outdoor environments. For example, on multiple-pane IG units provided with photocatalytic coating, the photocatalytic coating will commonly be provided on the #1 surface of the IG unit. Thus, when such IG units are installed in the wall of a building, the photocatalytic coating will tend to be exposed to a variety of contamination sources (painters finishing nearby areas of the building, etc.). While photocatalytic coatings may have some ability to remove such contaminants by virtue of photoactivity, excessive contamination and/or inorganic contamination may not be removed completely or quickly enough by the self-cleaning action of the coating. Therefore, it would be desirable to provide such photocatalytic coatings with temporary masking protection.

Given the activity of photocatalytic coatings, it would be desirable to provide masked photocatalytic products in which the masking and the coating complement each other. The properties and characteristics of the photocatalytic coating should not adversely impact the intended performance of the overlying masking. For example, direct contact between the photocatalytic coating and the masking should not unacceptably degrade any adhesive securing the masking to the coated surface. In most cases, it will be unacceptable for the activity of the photocatalytic coating to degrade such adhesive to the point where the masking actually falls, or sags, off the coated surface. Moreover, the activity of the coating should not alter the character of the masking adhesive in such a way that the adhesive and/or the masking film is rendered unacceptably difficult to remove from the coated surface. Similarly, the properties and characteristics of the masking should not adversely impact the intended performance of the photocatalytic coating. For instance, unacceptable adhesive transfer should not remain on the photocatalytic coating after the masking is removed. Moreover, the manner of applying and removing the masking should not score or otherwise permanently damage the photocatalytic coating.

The present invention provides masked photocatalytic glazing assemblies, and related methods (e.g., of manufacture and use), in which a photoactive coating and an overlying masking pay complements to each other.

### Summary of the Invention

In certain embodiments, the invention provides monolithic panes or insulating glazing units. Preferably, the monolithic pane or insulating glazing unit includes a photocatalytic coating that provides a self-cleaning and/or hydrophilic action. Here, the pane or IG unit has an exterior surface (e.g., an outboard surface, such as the #1 surface of an IG unit) bearing a photocatalytic coating. The photocatalytic coating preferably comprises a photocatalytic material, such as titanium oxide (e.g., TiO₂). The photocatalytic coating carries a masking comprising a removable (e.g., peelable) masking film, which in preferred embodiments is a flexible, self-supporting film (e.g., comprising plastic or the like). In some embodiments, the glazing is an IG unit having both sides (e.g., the #1 and #4 surfaces) covered with masking. The photocatalytic coating has a photoactivity within certain ranges in certain embodiments, the masking over the photocatalytic coating comprises a masking adhesive that is UV stabilized.

In certain embodiments, the invention provides a method of processing substrates. The method comprises providing a first sheet of glass, the first glass sheet having opposed first and second major surfaces. In the present embodiments, the first glass sheet is conveyed through a single sputter coater, and coatings are deposited onto both the first and second major surfaces in a single pass of the first glass sheet through the sputter coater. Here, the sputter depositing involves applying a photocatalytic coating to the first major surface of the first glass sheet by sputtering upwardly from a first sequence of targets. This sequence of targets includes one or more targets comprising a sputterable target material selected from the group consisting of a pure or substantially pure titanium material, a titanium alloy material, a titanium oxide material, and a compound including titanium and silicon. The sputter depositing also involves applying a low-emissivity coating to the second major surface of the first glass sheet by sputtering downwardly from a second sequence of targets. This sequence of targets includes one or more targets comprising a sputterable target material selected from the group consisting of a pure or substantially pure silver material and a silver alloy material. In the present embodiments, the thus coated first glass sheet is delivered to a multiple-pane insulating glass unit assembly line, the thus coated first glass sheet is conveyed along the assembly line, and the first glass sheet is assembled together with a second glass sheet, such that the resulting insulating glass assembly bounds a gap between the first and second glass sheets and the coated first major surface of the first glass sheet is an exterior surface oriented away from the gap. The present method comprises applying a peelable first masking over the photocatalytic coating. Here, the first masking comprises a masking substrate and a masking adhesive, and the application of the first masking over the photocatalytic coating involves adhering the masking adhesive directly to the photocatalytic coating. Preferably, the masking is applied by operating a first masking station, which desirably is part of the assembly line. In some cases, the method includes applying a peelable second masking over a #4 surface of the resulting insulating glass assembly, such application optionally being performed by operating a second masking station that is also part of the assembly line.

The invention provides an insulating glazing unit comprising two spaced-apart panes having a gap between them. In the present embodiments, there is a photocatalytic thin film coating on a desired major surface of one of the panes. This desired major surface is an exterior surface facing away from the gap. Further, a removable protective masking overlays the photocatalytic thin film coating. This masking comprises a masking substrate and a masking adhesive, and the masking adhesive is in direct adhesive contact with the photocatalytic thin film coating.

The invention provides an insulating glazing unit comprising two spaced-apart panes having a gap between them. In the present embodiments, there is a photocatalytic thin film coating on a desired major surface of one of the panes. This desired major surface is an exterior surface facing away from the gap. A removable protective masking overlays the photocatalytic thin film coating. This masking comprises a masking substrate and a masking adhesive, and the masking adhesive is in direct adhesive contact with the photocatalytic thin film coating. In the present embodiments, the removable protective masking is a peelable masking, and the masking adhesive has a higher level of adhesion to the masking substrate than to the coated major surface (and thus is adapted to adhere preferentially to the masking substrate when the masking is peeled off the coated major surface), such that when the masking is peeled off the coated major surface the adhesive adheres preferentially to the masking substrate.

### Description of the Drawings

Figure 1 is a perspective view of an insulating glass unit in accordance with an exemplary embodiment of the present invention.
Figure 2 is a cross-sectional view of an insulating glass unit in accordance with an exemplary embodiment of the present invention.
Figure 3 is a cross-sectional view of an insulating glass unit in accordance with an additional exemplary embodiment of the present invention.
Figure 4 is a perspective view of an assembly in accordance with an additional exemplary embodiment of the present invention.
Figure 5 is an isometric view of a workstation that can be used to apply masking to a monolithic pane or an insulating glass unit.
Figure 6 is an isometric view showing a production process (e.g., performed on a production line) for applying protective coverings to both sides of a monolithic pane or an insulating glass unit.
Figure 7 is a diagrammatic top view of an assembly comprising an insulating glass unit and a first sash piece.
Figure 8 is a diagrammatic top view of an assembly comprising an insulating glass unit and a first sash piece.
Figure 9 is a perspective view of an assembly in accordance with an exemplary embodiment of the present invention.
Figure 10 is a cross sectional view illustrating an assembly in accordance with an additional exemplary embodiment of the present invention.
Figure 11 is a flow chart exemplifying a production process in accordance with an exemplary embodiment of the invention.
Figure 12 is a schematic side view of a coater used in a production process of certain embodiments of the invention.

### Detailed Description

The following detailed description should be read with reference to the drawings, in which like elements in different drawings are numbered identically. The drawings, which are not necessarily to scale, depict selected embodiments and are not intended to limit the scope of the invention. Examples of constructions, materials, dimensions, and manufacturing processes are provided for selected elements. All other elements employ that which is known to those of skill in the field of the invention. Those skilled in the art will recognize that many of the examples provided have suitable alternatives that can be utilized.

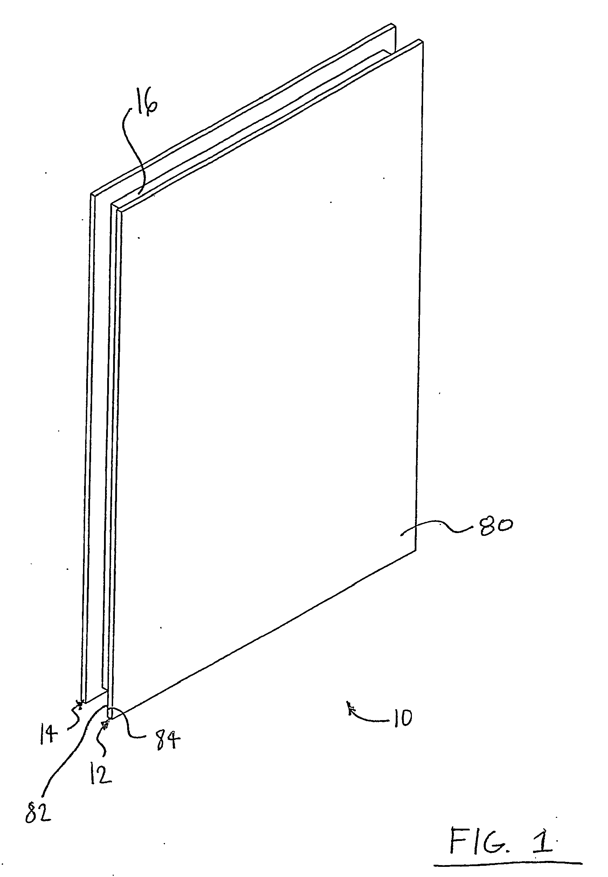

Figure 1 is a perspective view of an insulating glazing unit 10 in accordance with an exemplary embodiment of the present invention. Insulating glazing unit 10 comprises a first pane 12 having a first face 80, a second face 82, and a periphery 84 extending between first face 80 and second face 82. In the embodiment of figure 1, insulating glazing unit 10 also comprises a second pane 14 having a first face and a second face. In figure 1, it can be appreciated that a spacer 16 is interposed between the second face 82 of first pane 12 and the first face of second pane 14. The spacer can be part of a sash/frame, or it can be a conventional discrete spacer.

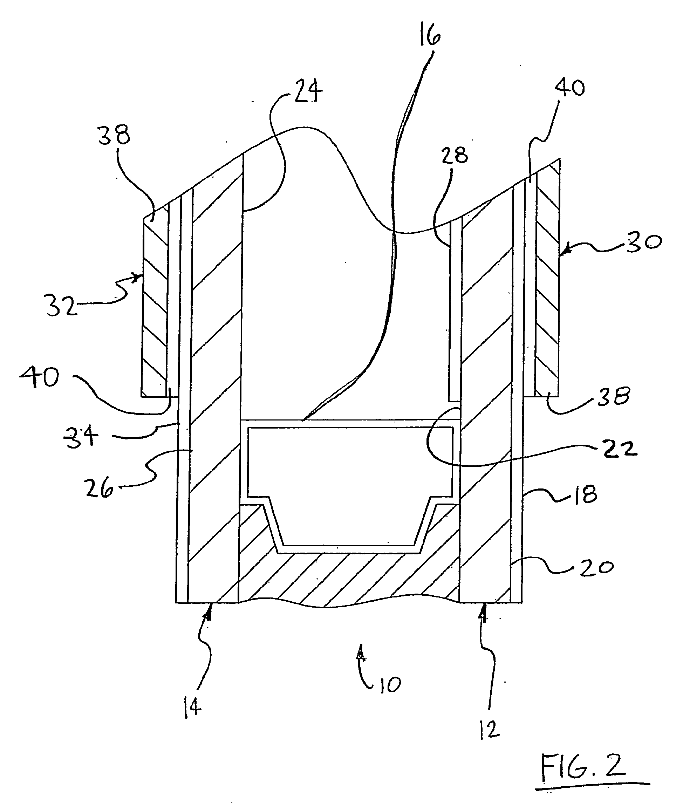

Figure 2 is a cross-sectional view of an insulating glazing unit 10 in accordance with an exemplary embodiment of the present invention. Insulating glazing unit 10 comprises a first pane 12, a second pane 14, and a spacer 16 interposed between first pane 12 and second pane 14. The spacer 16 in some embodiments can be an integral part of a sash, frame, etc. Insulating glazing unit has a #1 surface 20, a #2 surface 22, a #3 surface 24 and a #4 surface 26. With reference to figure 2, it will be appreciated that first pane 12 comprises #1 surface 20 and #2 surface 22. In the embodiment of figure 2, a first coating 18 is disposed on #1 surface 20 of first pane 12. Also in the embodiment of figure 2, a second coating 28 is disposed on #2 surface of first pane 12. Second pane 14 of insulating glazing unit 10 comprises #3 surface 24 and #4 surface 26. In the embodiment of figure 2, a third coating 34 is disposed on the #4 surface 26.

In other embodiments, which are particularly preferred, the #1 and #2 surfaces of a double-pane IG unit each bear coatings 18, 28, while the #3 and #4 surfaces are uncoated. Preferably, in these particular embodiments, the coating 18 on the #1 surface carries (e.g., is covered by) a first masking 30. Additionally or alternatively, the uncoated #4 surface 26 can carry a masking 32. When provided, one or both maskings 30, 32 preferably can be removed by peeling. Further, one or both maskings 30, 32 can optionally comprise a plurality of overlapped masking strips, the overlapped strips optionally being adhesively connected to the pane (and to each other by virtue of adhesive connecting their overlapping portions).

In embodiments wherein the #4 surface of the IG unit is coated, this coating can be a photocatalytic coating or a non-photocatalytic hydrophilic coating, such as a water-sheeting silica coating. Exemplary water-sheeting silica coatings (as well as useful deposition equipment and methods) are described in U.S. PATENT 7294403. The #2 surface coating is a low-emissivity coatings. Exemplary low-emissivity coatings are described in U.S. patent application # 2004146721. These coatings comprise a silver or silver-containing film located between two transparent dielectric films. Exemplary solar control coatings are described in U.S. Patent 5,698,262.

One embodiment provides a removable protective masking selected so as to be sufficiently opaque to ultraviolet radiation to substantially preclude (e.g., to have an ultraviolet transmission of less than 30%) ultraviolet radiation from reaching the photocatalytic film underlying the protective masking. In some such cases, an opaque masking film is provided.

In figure 2, a first masking 30 is overlaying first coating 18 and an optional second masking 32 is overlaying fourth coating 36. Each masking comprises a substrate 38 and an adhesive layer 40. In some useful embodiments, adhesive layer 40 comprises an acrylic adhesive. In some useful embodiments, adhesive layer 40 comprises at least one UV stabilizer. One particular group of embodiments provides an adhesive layer 40 comprising an acrylic adhesive that includes at least one UV stabilizer.

In some useful embodiments, adhesive layer 40 comprises at least one hindered amine. Examples of hindered amines that may be suitable in some applications include: bis-(2,2,6,6-tetramethyl-4-piperidyl)sebacate, bis-(1,2,2,6,6-pentamethyl-4-piperidyl)sebacate, polycondensate of succinic acid with N-(2-hydroxyethyl)-4-hydroxy 2,2,6,6-tetramethyl piperidine, poly-([6-[(1,1,3,3-tetramethylbutyl)-imino]-1,3,5-triazine-2,4-diyl] [2-(2,2,6,6-tetramethyl-4-piperidyl)imino]-hexamethylene-[4-(2,2,6,6-tetra methyl-4-piperidyl)imino]), 1-[2-[3-(3,5-di-t-butyl-4-hydroxyphenyl)-propionyloxy]ethyl]-4-[3-(3,5-di- t-butyl-4-hydroxyphenyl)-propionyloxy]-2,2,6,6-tetramethyl piperidine, tetrakis(2,2,6,6-tetramethyl-4-piperidyl)-1,2,3,4-butane tetracarboxylic esters, tetrakis(1,2,2,6,6-pentamethyl-4-piperidyl)-1,2,3,4-butane tetracarboxylic esters, polycondensate of N,N'-bis(2,2,6,6-tetramethyl-4-piperidyl)hexamethylene diamine with 1,2-dibromoethane, and polycondensate of 1,6-bis-(2,2,6,6-tetramethyl-4-piperidylamino)hexane with 2,4-dihalo-6-morpholino-1,3,5-triazine. Adhesive layer 40 may be an acrylic adhesive that includes at least one hindered amine, such as one selected from the group consisting of the list above in this paragraph. The adhesive 40 can optionally include one or more of the hindered amines that comprise tetramethyl piperidine derivatives.

According to the present invention, first coating 18 comprises at least one region or thickness comprising photocatalytic film. The photocatalytic film can comprise (e.g., can be) any photoactive material, such as titanium oxide (e.g., TiO₂). The photoactive material preferably is one that characteristically has the ability, at least above certain minimum thicknesses, to absorb ultraviolet radiation and photocatalytically degrade organic materials that contact the photocatalytic film. In certain embodiments, the masking adhesive and the photocatalytic film are jointly selected so as to complement each other. In some cases, the photoactivity of the photocatalytic film is just powerful enough to provide hydrophilicity, without creating a great self-cleaning effect. It has been discovered that providing a particularly powerful photocatalytic film is less than ideal in that such a film tends to leave the coated surface more dirty looking than is ideal. The photocatalytic film can be selected so as to have a level of photoactivity that is just high enough to enable the photocatalytic film to degrade adhesive residue left on the first coating after the masking is removed.

The invention provides a masked photocatalytic glazing assembly comprising a pane (of a monolithic glazing assembly or a multiple-pane insulating glazing unit) directly on a major surface of which is an exceptionally thin photocatalytic coating (e.g., a coating having at least one region or thickness comprising photocatalytic film), directly on which is a layer of masking adhesive, directly on which is a masking substrate (e.g., a flexible, self-supporting film that can be peeled off the coated major surface, such that when this film is peeled off the coated major surface, the adhesive adheres preferentially to the masking film and does not transfer, at least not substantially, to the coated major surface). Thus, the masking adhesive 40 has a stronger level (or force) of adhesion to the masking substrate than to the coated surface of the pane. The removable protective masking is a peelable masking, and the masking adhesive has a higher level of adhesion to the masking substrate than to the photocatalytic coating, such that when the masking is peeled off the coated major surface the adhesive adheres preferentially to the masking substrate. In these embodiments, the masking substrate 38 and/or the masking adhesive 40 optionally comprise at least one UV stabilizer and/or at least one UV blocker. Preferably, UV stabilizer is incorporated into the adhesive.

The photocatalytic film has a level of photoactivity that is low enough that it will not destroy the bond between the adhesive and the masking film or the bond between the adhesive and the pane. Thus, the masking film preferably will not fall or sag off the pane due to the adhesive being unacceptably degraded by photoactivity of the coating 18. The photocatalytic film can be selected so as to have a level of photoactivity that is just high enough to enable it to degrade adhesive residue left on the coating 18 when the masking 30 is removed. The masking adhesive is selected so that it does not exhibit adhesive transfer when the masking is removed.

For purposes of this disclosure, the activity of the photocatalytic film can be measured in terms of a desired photocatalytic reaction rate, such as the removal of a stearic acid test film under exposure to ultraviolet radiation from a light source having an intensity of about 20 watts per square meter at the film surface (e.g., sold commercially by the Q-panel Company of Cleveland, Ohio, U.S.A. under the trademark UVA-340). The ultraviolet radiation intensity can be at least about 20 watts per square meter at the coated surface of the photocatalytic film being tested. The intensity can optionally be set using an ultraviolet meter such as that sold by Ultraviolet Products, Inc. of San Gabriel, California, U.S.A. (e.g., under the trademark BLACK-RAY). The light source can be positioned normal to the coated surface of the photocatalytic film being tested. Exemplary methods are discussed in U.S. Patent No. 6,027,766.

Briefly, the photocatalytic film and the ultraviolet radiation source can be positioned relative to each other so that the ultraviolet radiation passes first through the photocatalytic film and then through the substrate. Here, the light source faces the front of the coated pane. In cases where the pane is formed of material (e.g., glass) through which ultraviolet radiation can pass, the photocatalytic film and the ultraviolet radiation source can be positioned relative to each other so that the ultraviolet radiation passes first through the pane and then through the photocatalytic film. Here, the light source faces the back of the coated pane. Alternatively, a light source can be positioned on both sides of the pane.

In more detail, an organic contaminant can be applied over the photocatalytic film and upon irradiating the film the ability of the film to remove the contaminant can be observed and measured. Stearic acid (CH₃(CH₂)₁₆COOH) is one useful contaminant. Stearic acid can be applied over the photocatalytic film as a thin test film by any desired technique, such as by spray coating, dip coating, or spin coating. Stearic acid test film thicknesses can optionally range between about 100 angstroms and about 200 angstroms. The test film, for instance, can be applied as stearic acid in a methanol solution, such as a solution having a concentration of 6×10⁻³ moles of stearic acid per liter of solution.

The reported method for measuring the activity of the photocatalytic film is to measure the integrated intensity of the carbon-hydrogen stretching vibrational absorption bands of the stearic acid on the photocatalytic film. The integrated intensity reflects the thickness of stearic acid test film on the photocatalytic film. As the stearic acid test film is removed, this is believed to result in a drop of the carbon-hydrogen stretching vibrational band intensity. The carbon-hydrogen bonds in the stearic acid absorb infrared radiation which unlike ultraviolet radiation does not activate the photocatalytic film. Generally, such absorption occurs between 2800 and 3000 cm⁻¹ wave numbers, and can be measured with a Fourier Transform Infrared Spectrophotometer. This spectrophotometer can be equipped with a detector like a deuterated triglycine sulface detector or a mercury-cadmium-telluride detector. The mercury-cadmium-telluride detector is reported to be preferred, particularly where the pane, the photocatalytic film, or another film on the pane absorb the infrared radiation that is used by the spectrophotometer to generate the absorption spectrum. When infrared radiation is so absorbed, the infrared radiation that passes through the stearic acid test film is reduced. This is combined with a low concentration of stearic acid on the photocatalytic film. Given this, the mercury-cadmium-telluride detector is reported to provide a spectrum with a signal-to-noise ratio that is about an order of magnitude better than a deuterated triglycine sulface detector. When the activity of a stearic acid test film deposited over the photocatalytic film is tested, the infrared radiation can optionally be directed through the pane and the photocatalytic film onto a detector on an opposite side of the pane being tested. Where infrared radiation is not able to pass through the substrate, the infrared radiation can optionally be directed over the surface at an angle, passing through the test film and reflecting off of the pane. Such method is known as reflection IR spectroscopy.

Thus, it is possible to consider the reaction rate of a photocatalytic film by measuring the rate at which the photocatalytic film reacts to remove the stearic acid test film when the photocatalytic film is exposed to actinic radiation. The rate of decrease in the integrated intensity of the carbon-hydrogen stretching vibrational feature is reported to be directly proportional to the surface coverage. Increasing the time of exposure to actinic (ultraviolet) radiation then gives the reaction rate. An initial activity can be measured with the spectrophotometer for a stearic acid test film on the photocatalytic film 18. The photocatalytic film can optionally have been exposed to ultraviolet radiation for the initial activity measurement. The stearic acid coated photocatalytic film can then be exposed to ultraviolet radiation for a certain time period, at the end of which a second activity measurement can be made with the spectrophotometer. The integrated intensities of the carbon-hydrogen stretching vibrations in the second measurement should be lower than in the first measurement, as a portion of the stearic acid test film will have been removed due to exposure to ultraviolet radiation. From such two measurements, one can generate a curve of integrated intensity of carbon-hydrogen stretching vibrations versus time. The slope of such a curve gives the reaction rate. While two points can be plotted to give a curve, several measurements are preferably taken to give the curve. While the period of exposure to radiation between measurements can be kept constant or varied when taking more than two measurements (e.g., the cumulated time of exposure to ultraviolet radiation is used to plot the curve), the intensity and orientation of the ultraviolet radiation should be kept constant for all measurements taken when determining the reaction rate.

The invention provides a photocatalytic coating 18 that has a low level of photoactivity and is used when a masking film is carried directly against (e.g., via a masking adhesive sandwiched between the coating 18 and the masking substrate) the photocatalytic coating 18. The reaction rate reported herein is given in units of cm⁻¹min⁻¹. Higher values of reaction rate signify greater photoactivity. The coating 18 has a photocatalytic activity of less than about 1.5x10⁻³ cm⁻¹min⁻¹.

One embodiment provides: a pane (optionally a glass pane) having a first major surface directly over which is applied a photocatalytic coating 18 (comprising an active film comprising, consisting essentially of, or consisting of titania, the active film preferably having a thickness of less than about 150 angstroms, such as between 20 angstroms and 100 angstroms, or less than 100 angstroms, perhaps between 20 angstroms and 75 angstroms, and in some cases less than 75 angstroms, such as between 20 angstroms and 60 angstroms), the photocatalytic coating 18 having a particularly low photocatalytic activity, being within less than about 1.5x10⁻³ cm⁻¹min⁻¹, wherein a masking is carried by the photocatalytic coating 18 (e.g., such that the masking comprises a masking adhesive sandwiched directly between the photocatalytic coating 18 and a masking substrate). In these embodiments, the photocatalytic coating 18 (or at least a titania-comprising film thereof) is a sputtered film.

Thus, in certain embodiments, the photocatalytic thin film coating comprises an active film comprising titania, and the active film has a thickness of less than 100 angstroms, or even less than 75 angstroms.

Various sputter deposition techniques can be used. In certain particularly preferred embodiments, the photocatalytic coating 18 (or at least one film region thereof) is deposited by sputtering at a low temperature (e.g., while maintaining the substrate at below about 250 degrees Celsius, and more preferably below 200 degrees Celsius).

Sputtering is well known in the present art. Magnetron sputtering chambers and related equipment are commercially available from a variety of sources (e.g., Leybold). Useful magnetron sputtering techniques and equipment are described in U.S. Patent 4,166,018, issued to Chapin.

In certain favored methods of the invention, the photocatalytic coating 18 is applied to a substrate in a multiple-chamber sputtering line. Sputtering lines are well known in the present art. A typical sputtering line includes a series of sputtering chambers aligned and connected such that a sheet-like substrate can be passed from one chamber to the next by conveying the substrate horizontally over (e.g., while in direct contact with) spaced-apart transport rollers in each of the chambers (the rollers form a continuous path of substrate travel through the sputtering line). The substrate is typically conveyed at speeds of between about 2.5-13 m (100-500 inches) per minute.

In one particular method, the substrate is positioned at the inlet of the sputtering line and conveyed to a desired coat zone. This coat zone is provided with three cathodes that are adapted to deposit the first film. In more detail, each of these cathodes comprises a silicon sputtering target, though, other methods involve other materials for the first film (alternatively, this first film can be omitted entirely). The silicon targets in this coat zone can be sputtered in an oxidizing atmosphere to deposit a silicon dioxide film directly upon the first major surface of the substrate. This atmosphere may consist essentially of oxygen (e.g., about 100% O₂). Alternatively, this atmosphere may comprise Ar/O₂ (e.g., oxygen and up to about 40% argon). A power of about 38 kW can be applied to the first cathode, while a power of about 38 kW can be applied to the second cathode, and a power of about 38 kW can be applied to the third cathode. The substrate can be conveyed beneath all three of these targets at a rate of about 5 m (200 inches) per minute, while sputtering each of these targets at the noted power level, such that a silicon dioxide film is applied at a thickness of about 100Å. The silica film here can optionally be less than 100 angstroms, such as between 60 angstroms and 90 angstroms, e.g., about 75 angstroms. The thickness and composition of this optional first film can be varied as desired. In embodiments wherein one or more silicon targets are used, each silicon target can include some aluminum or another material to enhance the conductivity of the target.

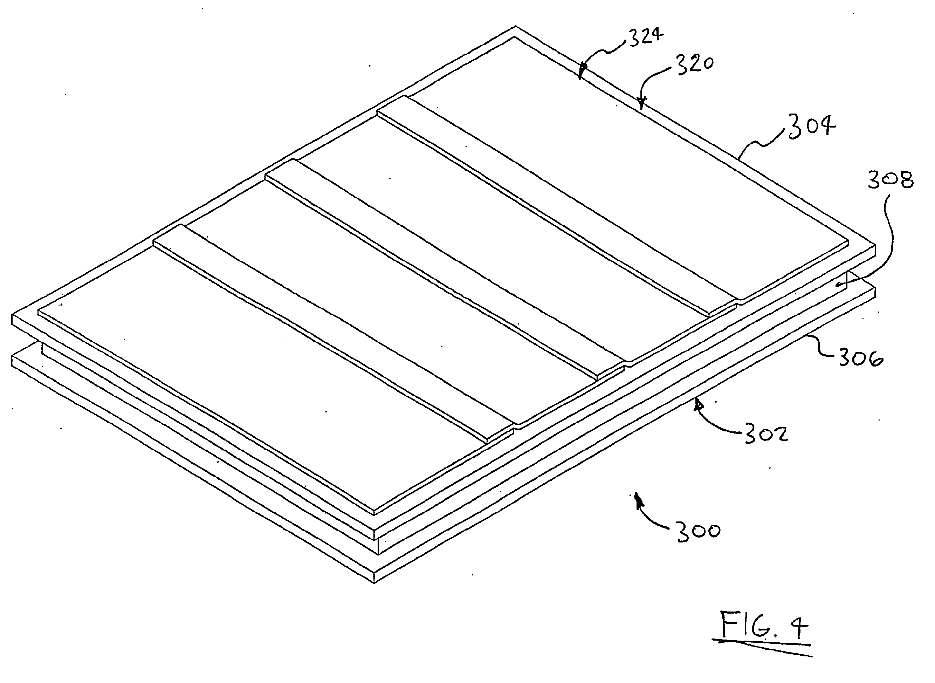

The thus coated substrate can then be conveyed into a subsequent coat zone. In this zone, three cathodes are used to deposit a second film. Preferably, each of these three cathodes comprises a titanium sputtering target. The titanium targets in this coat zone can be sputtered in an oxidizing atmosphere to deposit a titanium dioxide film directly upon the optional first film, when provided. Alternatively, such a titanium dioxide film can be deposited directly upon the substrate. Still further, two or more films can be deposited between the substrate and the titanium dioxide film. The atmosphere in which the titanium dioxide film is deposited may consist essentially of oxygen. Alternatively, this atmosphere may comprise Ar/O₂. A power of about 43 kW can be applied to the first cathode, a power of about 43 kW can be applied to the second cathode, and a power of about 43 kW can be applied to the third cathode. The substrate can be conveyed beneath all three of these targets at a rate of about 5 m (200 inches) per minute, while sputtering each of these targets at the noted power level, such that a titanium dioxide film is applied at a thickness of about 100Å. The titania film here can optionally be less than 100 angstroms, such as between 20 angstroms and 60 angstroms, e.g., about 25-40 angstroms. The thickness and composition of this film can be varied. In the present method, this titanium dioxide forms the outermost portion of the coating 18, although other embodiments involve an overlying thin film that does not eliminate the hydrophilicity imparted by the titanium dioxide. To achieve certain hydrophilicity properties (e.g., night-time properties), the titania can optionally be mixed with silica (or another non-photoactive, but hydrophilic, dielectric material). This can be done to achieve a desired balance of hydrophilic and photoactive properties, and may provide a suitably low level of activity to promote good masking durability. Preferably, directly over the outermost face of the coating 18 there is adhesively applied a first masking 30. This masking 30 can be applied as one single sheet of masking material or as a plurality of elongated masking strips applied in a sequentially-overlapping fashion wherein adjacent strips are overlapped in a side-over-side overlapping arrangement (e.g., as illustrated in figure 4). Optionally, the masked pane surface has a central region (e.g., which comprises the very center of the area of the masked pane surface), and one or more adhered masking strips are located over (e.g., so as to cover and extend beyond) this central region.

In the method just described, it is to be appreciated that the second major surface of the substrate may previously have been, or may subsequently be, coated with an optional low-emissivity coating. For instance, the coat zones just described for use in depositing the first and second films can be sputter-up coat zones (e.g., optionally located at the end of a sputtering line that includes a relatively large number of preceding sputter-down coat zones in which the optional low-emissivity coating may have been applied). Particularly useful sputter-up/sputter-down methods and equipment are described in U.S. patent application # 2005016835.

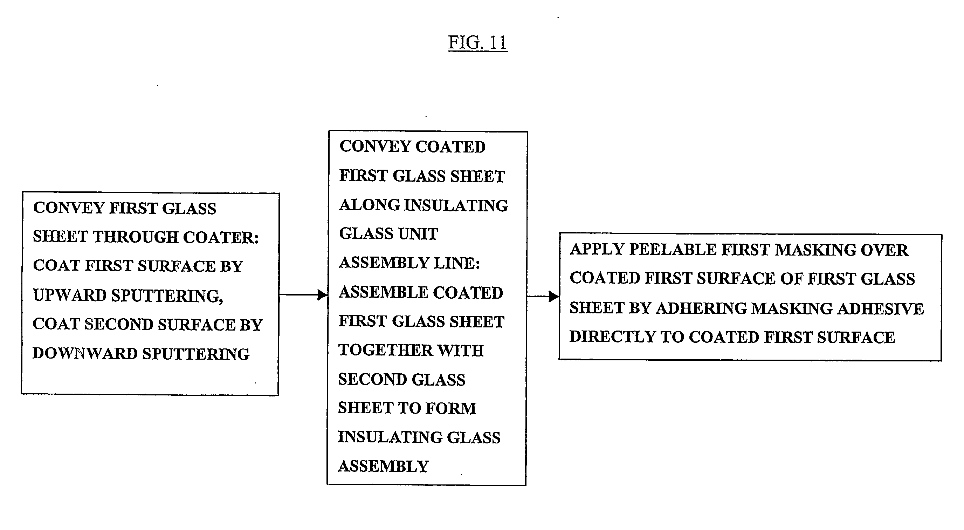

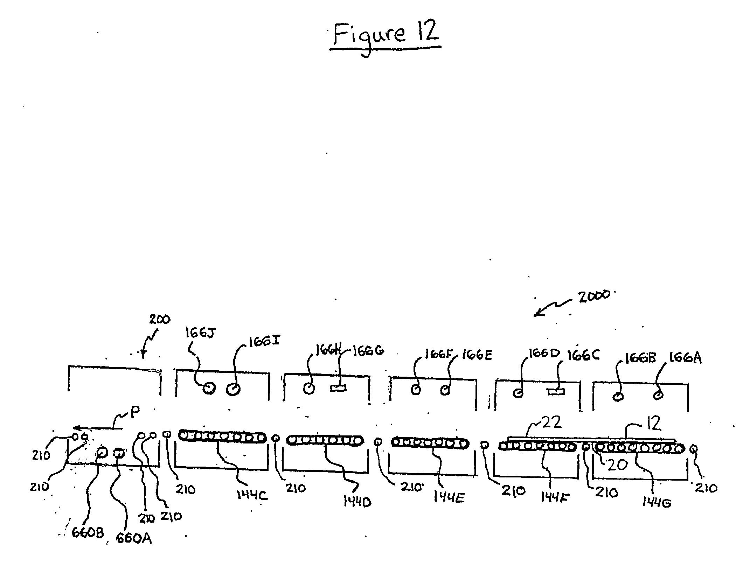

The invention provides a high efficiency production process for masked photocatalytic insulating glass technology. Here, the method involves a first stage sputter deposition process, followed by a second stage masking application process. The masking application is optionally carried out by operating a masking station that is part of an insulating glass unit assembly line. Reference is made to the process of figure 11 and the coater of figure 12. Preferably, the process includes: conveying a first glass sheet through a coater (e.g., a coater comprising a plurality of deposition bays/chambers connected in series along a continuous path of substrate travel), coating a first major surface of the glass sheet by upward sputtering, and coating a second major surface of the glass sheet by downward sputtering: then, the thus coated first glass sheet is conveyed along an insulating glass unit assembly line on which the first glass sheet is assembled together with a second glass sheet to form an insulating glass assembly; then, a peelable first masking is applied over the coated first surface of the first glass sheet by adhering masking adhesive directly to the coated first surface of the first glass sheet. In some embodiments, this masking application is carried out by operating a masking station that is part of the insulating glass unit assembly line. In one embodiment, this masking station is located at the end of the assembly line.

Figure 12 depicts an exemplary coater 2000 useful in the present production process. Here, the coater 2000 is seen to include at least six sputter deposition bays, although this is not required. The coater may advantageously include at least nine such bays, at least twelve such bays, or even at least fifteen such bays. The illustrated coater has as its last bay 200 (i.e., the last active bay along the path of substrate travel) a sputter-up bay/chamber. In another embodiment, the coater has a sputter-up bay/chamber as the first active bay on the path of substrate travel P. The illustrated chamber 2000 is shown as having a combination of transport rollers 210 and conveyor belts 144C-144G, although it may be preferable to simply use spaced-apart transport rollers (which are unconnected by a conveyor belt). In the illustrated coater, the first five bays are sputter-down bays, while the last bay is a sputter-up bay. As noted above, however, the arrangement and location of sputter-up bays and sputter-down bays can be adjusted to maximize efficiency or product integrity. Each illustrated bay is provided with two targets 166A-166J, 660A, 660B, although this is by no means required (e.g., a given chamber may have one target, three or more targets, or no targets, depending on the desired process).

The invention provides a method of processing substrates, where the method involves providing a first glass sheet, conveying this sheet through a single sputter coater, and sputter depositing coatings onto both first and second major surfaces of the glass sheet in a single pass of the sheet through the sputter coater. In the present group of embodiments, this sputter depositing involves applying a photocatalytic coating to the first major surface 20 of the glass sheet 12 by sputtering upwardly from a first sequence of targets 660A, 660B. Here, the first sequence of targets includes one or more targets comprising a sputterable target material selected from the group consisting of a pure or substantially pure titanium material, a titanium alloy material, a titanium oxide material, and a compound including titanium and silicon. This upward sputtering can optionally be carried out in a gaseous sputtering atmosphere containing an oxidizing gas and/or an inert gas. Suitable targets are available commercially from a number of suppliers, such as TICO Titanium Inc., New Hudson, Michigan, U.S.A. Substoichiometric TiOₓ targets, where x is less than 2, are described in U.S. Patent Nos. 6,461,686 and 6,468,402 and 6,511,587. Substoichiometric TiOₓ targets are commercially available from Bekaert VDS nv (Deinze, Belgium). Conjointly, the sputter depositing involves applying a low-emissivity coating to the second major surface of the first glass sheet by sputtering downwardly from a second sequence of targets. Here, the second sequence of targets optionally includes one or more targets comprising a sputterable target material selected from the group consisting of a pure or substantially pure silver material and a silver alloy material. Suitable targets of this nature are readily available from a number of commercial suppliers. The thus coated first glass sheet is then delivered to (e.g., positioned on) a multiple-pane insulating glazing unit assembly line and conveyed along the assembly line, on which this first glass sheet is assembled with a second glass sheet such that the resulting insulating glass assembly bounds a gap between the first and second glass sheets (the coated first major surface of the first glass sheet being an exterior surface oriented away from the gap). A peelable first masking is applied over the photocatalytic coating. The masking comprises a masking substrate and a masking adhesive. The application of the first masking over the photocatalytic coating involves adhering the masking adhesive directly to the photocatalytic coating. The applied masking adhesive desirably is selected so as to have a higher level of adhesion to the masking substrate than to the photocatalytic coating. In some cases, the application of the first masking over the photocatalytic coating involves operating a first masking station that is part of (i.e., is located on) the assembly line. Optionally, the present method includes applying a peelable second masking over a #4 surface of the resulting insulating glass assembly by operating a second masking station, which can advantageously be part of the assembly line as well.

In some of the embodiments described in the immediately preceding paragraph, the photocatalytic coating comprises an active film comprising titania, and this active film is sputter deposited at a thickness of less than 100 angstroms, as described below. Additionally or alternatively, the photocatalytic coating can optionally comprise an active film comprising titania, and this active film can be sputter deposited directly over an amorphous film.

In the present group of embodiments, the method can further comprise peeling the first masking off the major surface bearing the photocatalytic coating. During this peeling, the adhesive adheres preferentially to the masking substrate such that substantially all of the adhesive remains on the masking substrate once the first masking has been peeled off the major surface bearing the photocatalytic coating. As noted above, the masking adhesive can optionally be an acrylic adhesive, and/or the masking substrate can optionally comprise polyethylene, and/or the masking adhesive can optionally comprise at least one UV stabilizer.

It has been discovered that particularly thin photocatalytic coatings (sputtered titania) can provide exceptional results insofar as the above characteristics and advantages are concerned. In some embodiments, the photocatalytic coating has a total thickness of less than about 500 angstroms, preferably less than about 400 angstroms, perhaps less than about 300 angstroms, or even less than 200 angstroms (e.g., between 20 angstroms and 175 angstroms).

Certain embodiments involve a photocatalytic thin film coating comprising an active film comprising titania, the active film being deposited directly over an underlying film having a thickness of less than 200 angstroms, less than 100 angstroms, or even less than 75 angstroms. Moreover, in some cases, the titania-comprising film has no more than 200 angstroms, or no more than 100 angstroms, of total underlying film between it and the substrate.

In some embodiments, the photocatalytic thin film coating comprises an active film comprising titania, and the active film is deposited (i.e., positioned) directly over an amorphous film. The amorphous film, for example, can be a silica film, optionally comprising one or more metals (e.g., aluminum). In some cases, the amorphous film has a composition adapted to maintain a morphology that is at least substantially amorphous when subjected to glass tempering. A film comprising silica and a small amount of one or more metals is useful. Thus, in figure 2, for example, the innermost thickness (i.e., the thickness nearest the first pane 12) of the coating 18 can be a film underlying an active titania-comprising film (the active film optionally forming the outermost thickness of the coating 18).

It is often necessary to heat coated glass sheets to temperatures at or near the melting point of glass to temper the glass or to enable it to be bent into desired shapes. Tempering is desirable for glass used in automobile windows, for example, and particularly for glass used in automobile windshields. Further, tempered glass is commonly required in particular areas of buildings. Upon breaking, tempered glass desirably exhibits a break pattern in which the glass shatters into many small pieces, rather than into large dangerous shards. During glass tempering, coated glass is commonly subjected to elevated temperature on the order of about 700 degrees C.

In some embodiments, the invention provides a method that includes tempering a coated pane after the photocatalytic thin film coating has been applied to the substrate but before applying the removable protective masking over the photocatalytic thin film coating. Here, the photocatalytic coating will commonly be exposed (i.e., not covered) during the tempering. Preferably, the pane is glass and the heat treatment comprises: providing a coated glass of the described nature; and subjecting the thus-coated glass to an elevated temperature of between about 400 degrees C and about 750 degrees C, preferably between about 500 degrees C and about 750 degrees C, and perhaps more preferably between about 600 degrees C and about 750 degrees C. The tempering is preferably performed in an oxidizing atmosphere. For example, a single load of glass sheets can be positioned in a convection-type furnace and exposed to elevated temperatures reaching about 734 degrees C. The time taken to reach this temperature can be about 109 seconds. The coated glass can then be air quenched.

Following such an optional tempering procedure, the coated glass can be incorporated into a multiple pane IG unit, and the removable masking can be applied after the panes have been assembled into the IG unit, the method thus involving providing tempered glass panes, assembling two such panes into an IG unit, and thereafter applying the masking to the exterior major surface (e.g., the #1 surface) of one of the panes, optionally applying masking to both of the IG unit's exterior major surfaces (e.g., #1 and #4 surfaces). Here, the masking application can optionally be carried out on the same assembly line where the panes are assembled together into IG unit assemblies (e.g., on the same conveyor path).

The photocatalytic coating is applied by sputtering. Sputtering has been considered not to provide high levels of photoactivity. Thus, in embodiments of the invention providing one or more thin sputtered photocatalytic coatings that are masked, the inventors have turned this to their advantage by providing a masked, low-photoactivity coating that has masking stability and good hydrophilic coating properties upon removing the masking film, preferably without the high levels of photoactivity that have been found to result in less than ideal results in terms of the coated surface keeping a clean appearance.

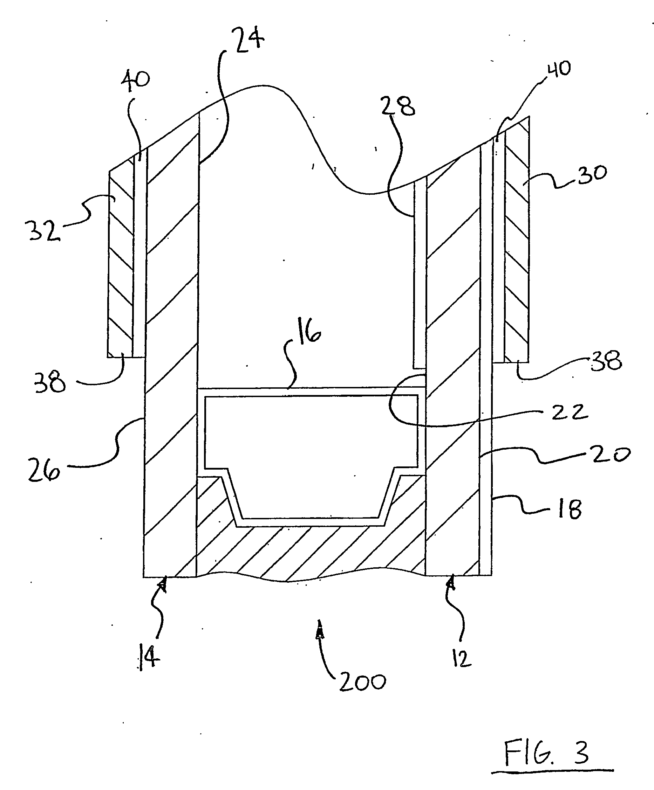

Figure 3 is a cross-sectional view of an insulating glazing unit 200 in accordance with an additional exemplary embodiment of the present invention. Insulating glazing unit 200 comprises a first pane 12, a second pane 14, and a spacer 16 interposed between first pane 12 and second pane 14. The spacer 16 in some embodiments can be integral to a sash, frame, etc. Insulating glazing unit has a #1 surface 20, a #2 surface 22, a #3 surface 24 and a #4 surface 26. With reference to figure 3, it will be appreciated that first pane 12 comprises #1 surface 20 and #2 surface 22. In the embodiment of figure 3, a first coating 18 is disposed on the #1 surface 20. Also in the embodiment of figure 3, a second coating 28 is disposed on the #2 surface. Second pane 14 of insulating glazing unit 200 comprises #3 surface 24 and #4 surface 26. With reference to figure 3, it will be appreciated that the #3 and #4 surfaces are uncoated. Here, the coated #1 surface carries a first masking 30 and the uncoated #4 surface carries a second masking 32. The first coating 18 desirably comprises (e.g., is) a photoactive coating, such as any of those described in the present disclosure.

Figure 4 is a perspective view of an assembly 300 in accordance with an exemplary embodiment of the present invention. Assembly 300 includes an insulating glazing unit 302. Insulating glazing unit 302 includes a first pane 304, a second pane 306 and a spacer 308 interposed between first pane 304 and second pane 306. First pane 304, second pane 306, and spacer 308 preferably define a between-pane space. In some embodiments, an insulative gas (e.g., argon, krypton, and/or others) is disposed within the between-pane space. Embodiments are also possible in which the between-pane space contains air or vacuum. Insulating glazing unit 302 may be generally referred to as a double glazed unit. The insulating glazing unit in any embodiment hereof can optionally be an insulating glass unit and/or can have a major dimension of less than 4 meters, less than 3 meters, less than 2.5 meters, less than 2 meters, or even less than 1.7 meters.

First pane 304 of insulating glazing unit 302 has a first face 320. In the embodiment of Figure 4, a temporary removable protective covering (or "masking") 324 is disposed over first face 320 of first pane 304. In the embodiment of Figure 4, protective covering 324 comprises a plurality of masking strips, each comprising a masking substrate (which preferably is flexible/non-rigid, such as a plastic or plastic-like material, optionally comprising polyethylene) with a masking adhesive disposed over a surface of the masking substrate.

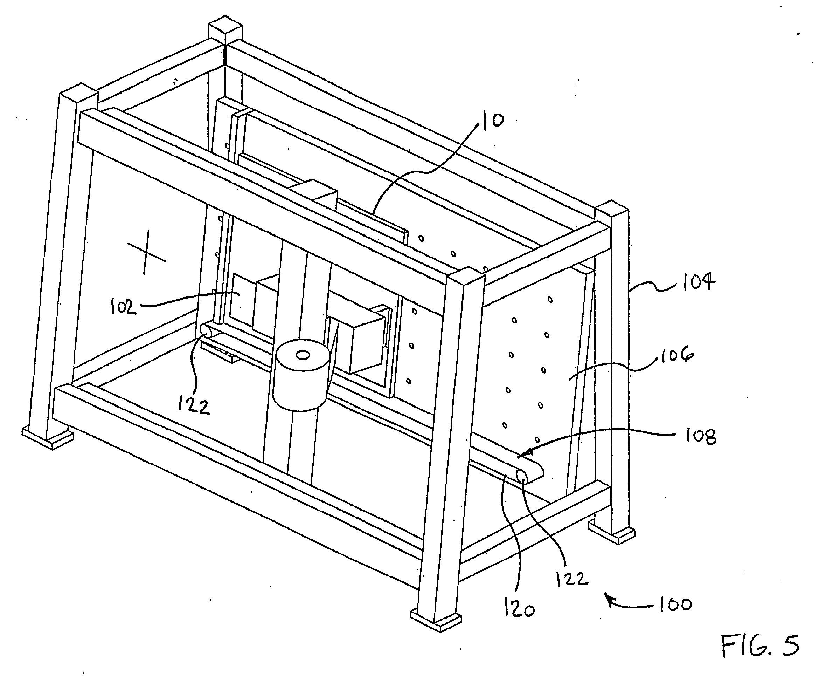

Figure 5 is an isometric view of a workstation 100 that can be used to apply a masking 102 to a monolithic pane or an insulating glazing unit 10. Workstation 100 includes a frame 104 supporting a work platen 106. The conveyor 108 can optionally take from (i.e., be adapted to receive glass pieces from) a preceding conveyor that is part of the assembly line on which monolithic panes are assembled together to form multiple-pane IG unit assemblies. Workstation 100 also includes a conveyor 108 extending across the front surface of work platen 106. Conveyor 108 may be utilized to transport a monolithic pane or an insulating glazing unit 10 through workstation 100. Conveyor 108 includes a belt 120 and a plurality of rollers 122. In the embodiment of figure 5, insulating glazing unit 10 is shown resting on belt 120 of conveyor 108. Workstation 100 may be incorporated into (e.g., may be part of) a longer assembly line having multiple work stations, each having a different function or effecting a step in processing a monolithic pane or an insulating glazing unit 10.

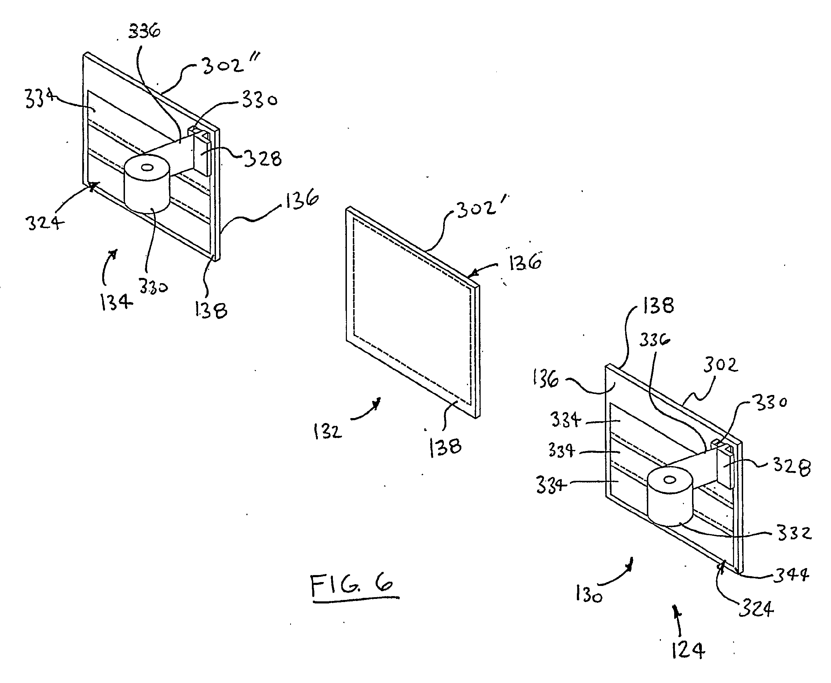

As noted above, some embodiments of the present invention include an insulating glazing unit that is masked on both sides. Figure 6 is an isometric view showing a process involving a production line 124 that is capable of applying masking to both sides of a monolithic pane or an insulating glazing unit. Production line 124 comprises a first workstation 130, a second workstation 132 and a third workstation 134. In this exemplary embodiment, first workstation 130 and third workstation 134 each comprise a workstation (optionally like workstation 100 shown in the previous figure) that is capable of applying protective covering (e.g., masking) 324 to a monolithic pane or an insulating glazing unit. Second workstation 132 is adapted for flipping an insulating glazing unit after the insulating glazing unit leaves first workstation 130 so that a masking can be applied to a second side 138 of the monolithic pane or insulating glazing unit by third workstation 134.

Insulating glazing units may be advanced through first workstation 130, second workstation 132 and third workstation 134 as part of a process for applying masking to both sides of the insulating glazing unit. In the embodiment of figure 6, a first insulating glazing unit 302 is disposed in a first workstation 130, a second insulating glazing unit 302' is disposed in second workstation 132 and a third insulating glazing unit 302" is disposed in third workstation 134.

First workstation 130 includes a first tool 328, a second tool 330, and a roll 332 of masking material 336. In the embodiment of figure 6, a plurality of sections 334 of masking material 336 have been applied to a first side 136 of first insulating glazing unit 302. First insulating glazing unit 136 also includes a second side 138. With reference to figure 6, it will be appreciated that the sections 334 of masking material 336 are positioned and dimension such to form a protective covering 324. In figure 6, an unmasked apron 344 is shown extending between protective covering (or "masking") 324 and an outer periphery of first insulating glazing unit 302. Preferably, when masking strips are secured to (e.g., when they are pressed adhesively onto) a major surface of a monolithic pane or a desired pane of an insulating glazing unit, they are spaced by an apron from the edge 84 of the pane so that no subsequent trimming of the masking is performed. Thus, in certain embodiments, there is provided a monolithic pane or IG unit having a major surface bearing a photocatalytic coating, and the method involves applying a masking (optionally comprising multiple strips, as described herein) adhesively over the photocatalytic coating (optionally so as to cover all but a peripheral area, or "apron", of the coated surface) without performing any subsequent cutting of the applied masking once it has been adhered to (e.g., so as to lie in its entirely parallel to) the coated surface. This can be done to avoid scoring the coating.

In figure 6, a second insulating glazing unit 302' is disposed in second workstation 132. With reference to figure 6, it will be appreciated that second insulating glazing unit 302' is oriented so that that the relative positions of first side 136 and second side 138 are reversed relative to first insulating glazing unit 302. A protective covering 324 that is disposed on first side 136 of second insulating glazing unit 302' is illustrated using dashed lines in figure 6. Third workstation 130 includes a first tool 328, a second tool 330, and a roll 332 of masking material 336. In the embodiment of figure 6, a plurality of sections 334 of masking material 336 have been applied to the second surface of third insulating glazing unit 302".

A method of masking both sides of a monolithic pane or an insulating glazing unit in accordance with the present invention includes the following steps. Transporting a monolithic pane or an insulating glazing unit 10 into first workstation 130. Applying protective covering (or "masking") 324 to a first side 136 of insulating glazing unit 10 (preferably over a photocatalytic coating 18). Transporting the monolithic pane or insulating glazing unit into second workstation 132. Flipping the monolithic pane or insulating glazing unit. Transporting the monolithic pane or insulating glazing unit into the third workstation 134. Applying protective covering 324 to the second side 138 of the monolithic pane or insulating glazing unit (e.g., by operating the third workstation 134).

With respect to the monolithic pane or multi-pane insulating glazing unit, a variety of pane substrates are suitable. Preferably, the substrate is a sheet-like substrate having generally or substantially opposed first and second major surfaces. In many embodiments, the substrate is a sheet of transparent material (i.e., a transparent sheet). The substrate, however, is not required to be transparent. For most applications, though, the substrate will comprise a transparent (or at least translucent) material, such as glass or clear plastic. For example, the substrate is a glass sheet (e.g., a glass window pane) in preferred embodiments. A variety of known glass types can be used, and soda-lime glass is commonly preferred. In some embodiments, each pane of a masked photocatalytic IG unit is a sheet of glass and the masking material is a transparent (e.g., optically clear) polymeric material, wherein optionally the IG unit has only two glass panes, the #1 and #4 surfaces of the IG unit are masked, the #1 surface bears the photocatalytic coating, and the #4 surface does not have any thin film coating underneath the masking.

Substrates (e.g., panes) of various sizes can be used in the present invention. Commonly, large-area substrates are used. Certain embodiments involve a substrate having a width of at least about .5 meter, preferably at least about 1 meter, perhaps more preferably at least about 1.5 meters (e.g., between about 2 meters and about 4 meters), and in some cases at least about 3 meters.

Substrates of various thicknesses can be used in the present invention. Commonly, substrates (e.g., glass sheets) having a thickness of about 1-5 mm are used. Certain embodiments involve a substrate with a thickness of between about 2.3 mm and about 4.8 mm, and perhaps more preferably between about 2.5 mm and about 4.8 mm. In some cases, a sheet of glass (e.g., soda-lime glass) with a thickness of about 3 mm will be used.

The masking can comprise a variety of materials. For example, the masking substrate will commonly be a film (which may be flexible, yet self supporting). Polymeric films are useful. For example, the masking substrate can be polyethylene (PE), polypropylene (PP), polyvinyl chloride (PVC), polyurethane, polytetrafluoroethylene (PTFE), polyester (e.g., PET), polyamide, or polyimide. The masking substrate may also be a mixture of films, such as a co-extruded polyethylene-polypropylene film. Useful masking films are commercially available from a number of suppliers, including Permacel (New Brunswick, New Jersey, USA), Poli-Film America (Hampshire, Illinois, USA), and American Biltrite Inc. (Morristown, New Jersey, USA), and Tekra Corporation (New Berlin, Wisconsin, USA).

In some particular embodiments, the masking adhesive is an acrylic adhesive and the masking substrate comprises (e.g., is) polyethylene. These embodiments are advantageous when it is desired to provide a peelable masking where the masking adhesive has a higher level of adhesion to the masking substrate than to the coated major surface, such that when the masking is peeled off the coated major surface the adhesive adheres preferentially to the masking film.

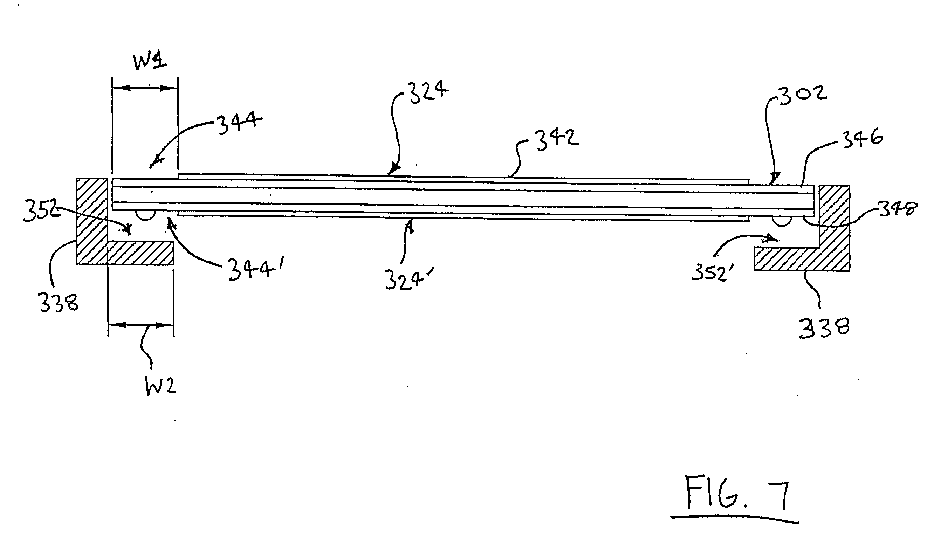

Figure 7 is a diagrammatic top view of an assembly in accordance with an exemplary embodiment of the present invention. The assembly of figure 7 includes an insulating glazing unit 302 (which in other embodiments can be replaced with a monolithic pane) and a first sash piece 338. In figure 7, it can be appreciated that a first protective covering 324 comprising a first masking strip 342 is disposed on a first (e.g., outboard) surface 346 of insulating glazing unit 302 and a second protective covering (or "masking") 324' is disposed on a second surface 348 of insulating glazing unit 302. In the embodiment of figure 7, a first unmasked apron 344 of first surface 346 extends between an outer periphery of first protective covering 324 and an outer periphery of insulating glazing unit 302. Similarly, a second unmasked apron 344' of second surface 348 extends between an outer periphery of second protective covering 324' and an outer periphery of insulating glazing unit 302. In the embodiment of figure 7, first unmasked apron 344 and second unmasked apron 344' each have a width W1. In the embodiment of figure 7, an optional adhesive bead 350 has been deposited on second unmasked apron 344' of second surface 348.

A first mating portion 352 and a second mating portion 352' of first sash piece 338 (which preferably comprises a rigid support member) are shown in figure 7. In the embodiment of figure 7, first mating portion 352 and second mating portion 352' both have a width W2. In the exemplary embodiment of figure 7, width W2 of first mating portion 352 is generally similar to (optionally substantially equal to) width W1 of second unmasked apron 344'. In some alternate embodiments of the present invention, the width of the second unmasked apron 344' is generally greater than the width of the mating portion of a sash piece. As another alternative, W1 can advantageously be smaller than W2.

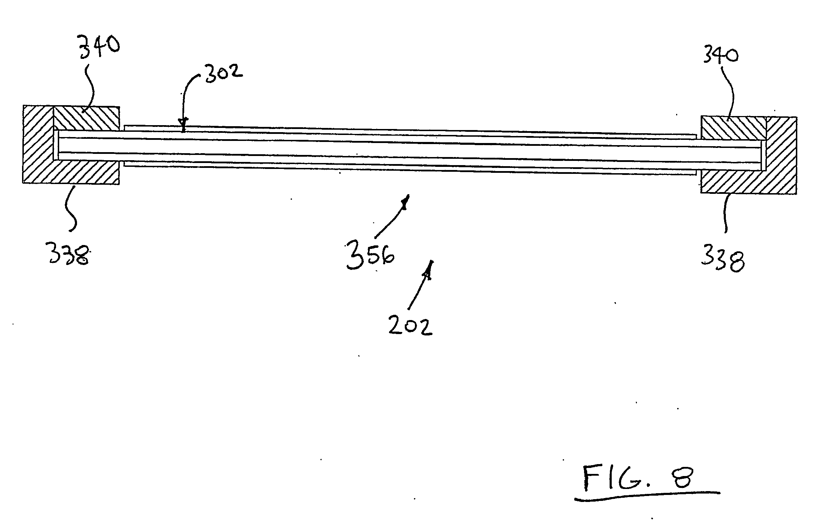

Figure 8 is a diagrammatic top view of an assembly 202 comprising insulating glazing unit 302 and first sash piece 338 shown in the previous figure. In figure 8 it may be appreciated that second unmasked apron 344' has been mated with first mating portion 352 and second mating portion 352' of first sash piece 338. Insulating glazing unit 302 may be fixed to first sash piece 338, for example, using an adhesive material. A second sash piece 340 is also shown in figure 8. Assembly 202 has a viewing area (or "vision area") 356 that is not covered by first sash piece 338 or second sash piece 340. Here, the masking can optionally cover substantially the entire vision area.

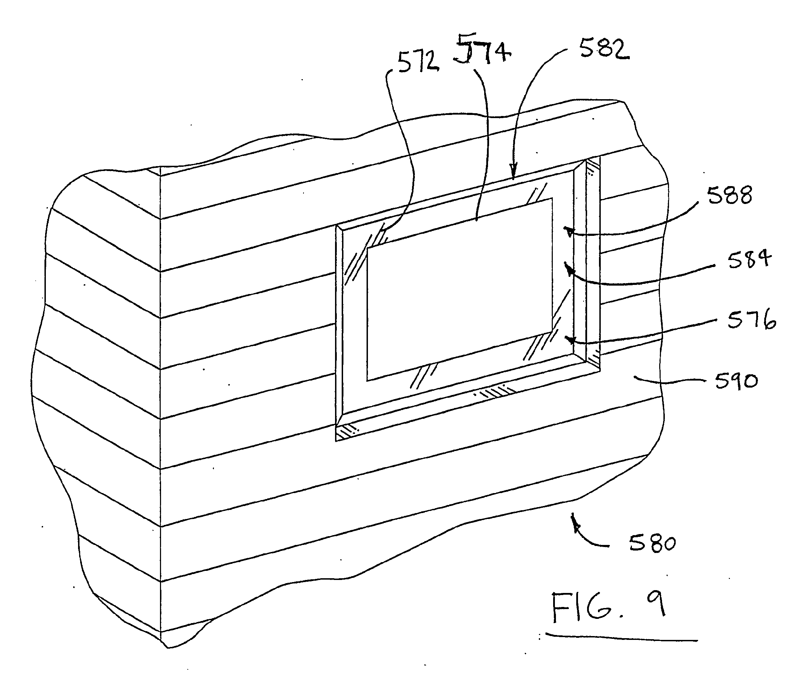

Figure 9 is a perspective view of an assembly in accordance with an additional exemplary embodiment of the present invention. A first wall 590 of a building 580 is visible in figure 9. First wall 590 defines an opening 582. An insulating glazing unit 588 is disposed in opening 582 defined by first wall 590. Insulating glazing unit 588 comprises a first pane 584 defining a #1 surface 576 of insulating glazing unit 588. In the embodiment of figure 9, a first coating 572 is disposed on #1 surface 576. First coating 572 on the #1 surface carries (e.g., is covered by) a first masking 574. In some useful embodiments, first coating 572 comprises a photocatalytic coating, such as any one of those described above. Preferably, the masking 574 covers more of the vision area than is illustrated in figure 9, such as all or substantially all of the vision area.

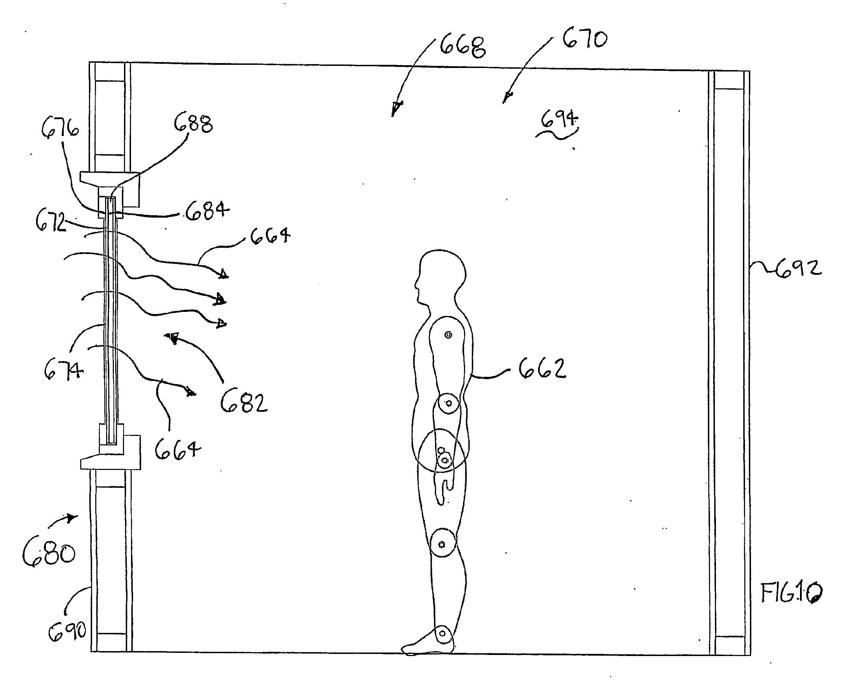

Figure 10 is a cross sectional view illustrating an assembly in accordance with an additional exemplary embodiment of the present invention. A first wall 690, a second wall 692 and a third wall 694 of a building 680 are visible in figure 10. First wall 690, second wall 692 and third wall 694 define an interior 668 of a room 670. First wall 690 defines an opening 682. An insulating glazing unit 688 is disposed in opening 682 defined by first wall 690.

Insulating glazing unit 688 comprises a first pane 684 defining a #1 surface 676 of insulating glazing unit 688 and a second pane 686 defining a #4 surface of insulating glazing unit 688. In the embodiment of figure 10, a first coating 672 is disposed on #1 surface 676. First coating 672 on the #1 surface carries (e.g., is covered by) a first masking 674. In some useful embodiments, first coating 672 comprises a photocatalytic coating, such as any one of those described above.

In the embodiment of figure 10, masking 674 comprises a substrate and an adhesive layer. In figure 10, rays of sunlight 664 are show passing through masking 674 and insulating glazing unit 688. In some useful embodiments of the present invention, masking 674 is sufficiently optically translucent (e.g., having a visible transmission of at least at least 30%, at least 40%, at least 50%, or at least 60%) to allow sunlight to illuminate room 670. In some useful embodiments of the invention, masking 674 is transparent (or at least substantially transparent) to visible radiation (e.g., has a visible transmission above 65%, 75%, or even 85%).

In some useful methods in accordance with the present invention, masking 674 remains fixed to insulating glazing unit 688 while a number of people (e.g., carpenters, painters, etc.) complete the erection and/or finishing of a building (e.g., house, office building, etc.) to which the insulating glazing unit 688 is attached (e.g., mounted). When this is the case, masking 674 may serve to protect insulating glazing unit 688 from damage while, at the same time, allowing room 670 to be illuminated by sunlight 664. Sunlight 664 may allow carpenters, painters, and other workers to perform work on building 680 without the use of artificial light.

Some further embodiments provide an apparatus comprising: at least one wall defining a room; the wall defining an opening; an insulating glazing unit disposed in the opening defined by the wall, the insulating glazing unit comprising two spaced-apart panes having a gap between them; a photocatalytic thin film coating on a desired major surface of one of the panes, the desired major surface being an exterior surface facing away from the gap; and a removable protective masking overlaying the photocatalytic thin film coating, the masking comprising a masking substrate and a masking adhesive, wherein the masking adhesive is in direct adhesive contact with the photocatalytic thin film coating. Optionally, the protective cover is sufficiently translucent, or transparent, to allow sunlight to illuminate the room. In some cases, the photocatalytic film has a thickness and composition selected such that the photocatalytic film is capable of degrading adhesive residue left on the coating after the selected masking is removed.

Numerous characteristics and advantages of the invention covered by this document have been set forth in the foregoing description. It will be understood, however, that this disclosure is, in many respects, only illustrative. Changes may be made in details, particularly in matters of shape, size and ordering of steps without exceeding the scope of the invention. The invention's scope is, of course, defined by the language in which the appended claims are expressed.

## Claims

1. A method of processing substrates, the method comprising:
a) providing a first sheet of glass, said first glass sheet having opposed first and second major surfaces;
b) conveying the first glass sheet through a single sputter coater, and sputter depositing coatings onto both the first and second major surfaces in a single pass of the first glass sheet through the sputter coater, said sputter depositing involving:
i) applying a photocatalytic coating to the first major surface of the first glass sheet by sputtering upwardly from a first sequence of targets, said first sequence of targets including one or more targets comprising a sputterable target material selected from the group consisting of a pure or substantially pure titanium material, a titanium alloy material, a titanium oxide material, and a compound including titanium and silicon;
ii) applying a low-emissivity coating to the second major surface of the first glass sheet by sputtering downwardly from a second sequence of targets, said second sequence of targets including one or more targets comprising a sputterable target material selected from the group consisting of a pure or substantially pure silver material and a silver alloy material;
c) delivering the thus coated first glass sheet to a multiple-pane insulating glazing unit assembly line;
d) conveying the thus coated first glass sheet along the assembly line and assembling such first glass sheet with a second glass sheet, such that the resulting insulating glass assembly bounds a gap between said first and second glass sheets and the coated first major surface of said first glass sheet is an exterior surface oriented away from said gap; and
e) applying a peelable first masking over the photocatalytic coating, said first masking comprising a masking substrate and a masking adhesive, wherein said application of the first masking over the photocatalytic coating involves adhering the masking adhesive directly to the photocatalytic coating, the photocatalytic coating having a photocatalytic activity (standard stearic acid test) of less than about 1.5 x 10⁻³ cm⁻¹min⁻¹, such that the photocatalytic activity of the photocatalytic coating is low enough that it will not destroy the bond between the masking adhesive and the masking substrate or the bond between the masking adhesive and said first major surface.

2. The method of claim 1, wherein the photocatalytic coating comprises an active film comprising titania, said active film being sputter deposited at a thickness of less than 100 angstroms.

3. The method of claim 1 or 2, wherein the photocatalytic coating comprises an active film comprising titania, the active film being sputter deposited directly over an amorphous film.

4. The method of any of the preceding claims, wherein said application of the first masking over the photocatalytic coating involves operating a first masking station, said first masking station being part of said assembly line.

5. The method of any of the preceding claims, comprising applying a peelable second masking over a #4 surface of said resulting insulating glass assembly by operating a second masking station, said second masking station also being part of said assembly line.

6. The method of any of the preceding claims, wherein said applied masking adhesive has a higher level of adhesion to the masking substrate than to the photocatalytic coating.

7. The method of claim 6, further comprising peeling the first masking off the major surface bearing the photocatalytic coating, during which peeling the adhesive adheres preferentially to the masking substrate such that substantially all of the adhesive remains on the masking substrate of the first masking once the first masking has been peeled off the major surface bearing the photocatalytic coating.

8. The method of any of the preceding claims, wherein the masking adhesive is an acrylic adhesive and the masking substrate comprises polyethylene.

9. The method of any of the preceding claims, wherein the masking adhesive comprises at least one UV stabilizer.

10. An insulating glazing unit comprising a first pane and a second pane, said two panes being spaced-apart having a gap between them; a low-emissivity coating on one major surface of at least the first pane, said major surface being an interior surface facing toward said gap; a photocatalytic thin film coating on a desired major surface of the first pane, said desired major surface being an exterior surface facing away from said gap; and a peelable protective masking overlaying the photocatalytic thin film coating, said masking comprising a masking substrate and a masking adhesive, wherein the masking adhesive is in direct adhesive contact with the photocatalytic thin film coating, the photocatalytic thin film coating having a photocatalytic activity (standard stearic acid test) of less than about 1.5 x 10⁻³ cm⁻¹min⁻¹, such that the photocatalytic activity of the photocatalytic thin film coating is low enough that it will not destroy the bond between the masking adhesive and the masking substrate or the bond between the masking adhesive and said desired major surface.

11. The insulating glazing unit of claim 10, wherein the masking adhesive has a higher level of adhesion to the masking substrate than to said coated major surface, such that the adhesive is adapted to adhere preferentially to the masking substrate when the masking is peeled off said coated major surface.

12. The insulating glazing unit of claim 10 or 11, wherein the masking adhesive is an acrylic adhesive and the masking substrate comprises polyethylene.

13. The insulating glazing unit of claim 10, 11 or 12, wherein the masking adhesive comprises at least one UV stabilizer.

14. The insulating glazing unit of any of claims 10-13, wherein the masking adhesive comprises at least one hindered amine.

15. The insulating glazing unit of claim 14, wherein the hindered amine comprises tetramethyl piperidine derivative.

16. The insulating glazing unit of claim 15, wherein the hindered amine is selected from the group consisting of: the polycondensation product of 1 -(2-hydroxyethyl)-2,2,6,6-tetramethyl-4- hydroxypiperidine and succinic acid; the polycondensation product of 4,4'-hexam ethyl ene-bis(amino-2,2,6,6-tetramethylpiperidine) and 2,4-dichloro-6-tert-octylamino-s-triazine; the polycondensation product of 4,4'-hexamethylene-bis(amino-2,2,6,6-tetramethylpiperidine) and 2,4-dichloro-6-cyclohexylamino-s-triazine; the polycondensation product of 4,4'-hexamethylene-bis(amino-2,2,6,6-tetramethylpiperidine) and 2,4-dichloro-6-morpholino-s-triazine; poly[methyl 3-(2,2,6,6-tetramethylpiperidin-4-yloxy)propyl]siloxane; bis(2,2,6,6-tetramethylpiperidin-4-yl) cyclohexylenedioxydimethylmalonate; 1,355-tris{N-cyclohexyl-N-[2-(2,2,6,6-tetramethyl[rho]iperazin-3-on-4-yl)ethyl] amino-s-triazine; N,N<I>,N",N"'-tetrakis[4,6-bis(butyl-(2,2,6:>6-tetramethylpi[rho]eridin-4-yl)amino )-s- triazin-2-yl]- 1 , 10-diamino-4,7-diazadecane; and the polycondensation product of 2,4-dichloro-6-(2,2,6,6-tetramethylpiperidin-4- yl)butylammo-s-triazine and 2,2'-ethylene-bis {[2,4-(2,2,6,6-tetramethylpiperidin-4-yl)butylamino-s-triazin-6-yl] amino trimethyleneamino}.

17. The insulating glazing unit of any of claims 10-16, wherein the photocatalytic thin film coating comprises an active film comprising titania, said active film having a thickness of less than 100 angstroms.

18. The insulating glazing unit of claim 17, wherein the thickness of the active film is less than 75 angstroms.

19. The insulating glazing unit of any of claims 10-18, wherein the photocatalytic thin film coating comprises an active film comprising titania, the active film being deposited directly over an amorphous film.

20. The insulating glazing unit of claim 19, wherein the amorphous film has a composition adapted to maintain a morphology that is at least substantially amorphous when subjected to glass tempering.

21. The insulating glazing unit of any of claims 10-20, wherein the photocatalytic thin film coating comprises an active film comprising titania, the active film being deposited directly over an underlying film having a thickness of less than 200 angstroms.

22. The insulating glazing unit of claim 21, wherein the thickness of the underlying film is less than 100 angstroms.

23. The insulating glazing unit of claim 11, wherein the insulating glazing unit is further provided with a masked #4 major surface, the masked #4 surface carrying a second peelable masking.

## Patentansprüche

1. Verfahren zum Bearbeiten von Substraten, wobei das Verfahren umfasst:
a) Bereitstellen einer ersten Lage Glas, wobei die erste Glaslage eine einander entgegengesetzte erste und zweite Hauptfläche aufweist;
b) Befördern der ersten Glaslage durch einen einzelnen Kathodenzerstäuber und Abscheiden von Zerstäuberschichten auf der ersten und der zweiten Hauptfläche in einem einzigen Durchgang der ersten Glaslage durch den Kathodenzerstäuber, wobei die Zerstäuberabscheidung beinhaltet:
i) Aufbringen einer photokatalytischen Schicht auf die erste Hauptfläche der ersten Glaslage durch Zerstäuben aufwärts von einer ersten Folge von Targets, wobei die erste Folge von Targets ein oder mehrere Targets enthält, die ein zerstäubungsfähiges Targetmaterial ausgewählt aus der Gruppe bestehend aus reinem oder im Wesentlichen reinem Titanmaterial, einem Titanlegierungsmaterial, einem Titanoxidmaterial und einer Verbindung enthaltend Titan und Silizium umfasst;
ii) Aufbringen einer Schicht mit geringem Emissionsvermögen auf die zweite Hauptfläche der ersten Glaslage durch Zerstäuben abwärts einer zweiten Sequenz von Targets, wobei die zweite Sequenz von Targets ein oder mehrere Targets enthält, die ein zerstäubungsfähiges Targetmaterial ausgewählt aus der Gruppe bestehend aus reinem oder im Wesentlichen reinem Silbermaterial und einem Silberlegierungsmaterial umfasst;
c) Übergeben der so beschichteten ersten Glaslage an eine Montagelinie einer Mehrfachscheiben-Isolierverglasungseinheit;
d) Fördern der auf diese Weise beschichteten ersten Glaslage entlang der Montagelinie und Zusammenbauen einer solchen ersten Glaslage mit einer zweiten Glaslage, derart, dass die resultierende Isolierglaseinheit einen Spalt zwischen der ersten und zweiten Glaslage einbindet und die beschichtete erste Hauptfläche der ersten Glaslage eine Außenfläche ist, die von dem Spalt weggerichtet ist; und
e) Aufbringen einer abziehbaren ersten Maske über der photokatalytischen Schicht, wobei die erste Maske ein Maskensubstrat und ein Maskenhaftmittel umfasst, wobei die Aufbringung der ersten Maske über der photokatalytischen Schicht beinhaltet ein Anhaften des Maskenhaftmittels direkt auf der photokatalytischen Schicht, wobei die photokatalytische Schicht aufweist eine photokatalytische Aktivität (Standard-Stearinsäuretest) von weniger als etwa 1,5 x 10⁻³ cm⁻¹min⁻¹, derart, dass die photokatalytische Aktivität der photokatalytischen Schicht niedrig genug ist, dass sie die Bindung zwischen dem Maskenhaftmittel und dem Maskensubstrat oder die Bindung zwischen dem Maskenhaftmittel und der ersten Hauptfläche nicht zerstören wird.

2. Verfahren nach Anspruch 1, in welchem die photokatalytische Schicht einen aktiven Film mit Titanidin aufweist, wobei der aktive Film durch einen Zerstäuber mit einer Dicke von weniger als 100 Ångström abgeschieden wird.

3. Verfahren nach Anspruch 1 oder 2, in welchem die photokatalytische Schicht einen aktiven Film mit Titanidin aufweist, wobei der aktive Film durch einen Zerstäuber direkt über einen amorphen Film abgeschieden wird.

4. Verfahren nach einem der vorhergehenden Ansprüche, in welchem die Aufbringung der ersten Maske über der photokatalytischen Schicht ein Betreiben einer ersten Maskenstation umfasst, wobei die erste Maskenstation ein Teil der Montagelinie ist.

5. Verfahren nach einem der vorhergehenden Ansprüche, mit einem Aufbringen einer abziehbaren zweiten Maske einer #4 Oberfläche der resultierenden Isolierglaseinheit durch Betreiben einer zweiten Maskenstation, wobei die zweite Maskenstation auch Teil der Montagelinie ist.

6. Verfahren nach einem der vorhergehenden Ansprüche, in welchem das aufgebrachte Maskenhaftmittel einen höheren Grad einer Haftung an dem Maskensubstrat hat als an der photokatalytischen Schicht.

7. Verfahren nach Anspruch 6, ferner mit einem Abziehen der ersten Maske von der Hauptfläche, welche die photokatalytische Schicht trägt, wobei während dieses Abziehens das Haftmittel vorzugsweise an dem Maskensubstrat derart haftet, dass im Wesentlichen das gesamte Haftmittel an dem Maskensubstrat der ersten Maske verbleibt, wenn die erste Maske von der Hauptfläche abgezogen worden ist, welche die photokatalytische Schicht trägt.

8. Verfahren nach einem der vorhergehenden Ansprüche, in welchem das Maskenhaftmittel ein Acrylhaftmittel ist und das Maskensubstrat Polyethylen umfasst.

9. Verfahren nach einem der vorhergehenden Ansprüche, in welchem das Maskenhaftmittel wenigstens einen UV-Stabilisator umfasst.

10. Isolierglaseinheit mit einer ersten Scheibe und einer zweiten Scheibe, wobei die zwei Scheiben mit einer Lücke zwischen ihnen in Abstand angeordnet sind; einer Schicht mit geringer Emissionsaktivität auf einer Hauptfläche wenigstens der ersten Scheibe, wobei die Hauptfläche eine Innenfläche ist, die dem Spalt zugewandt ist; einer photokatalytischen dünnen Filmschicht auf einer erwünschten Hauptfläche der ersten Scheibe, wobei die erwünschte Hauptfläche eine Außenfläche ist, die dem Spalt abgewandt ist; und einer abziehbaren Schutzmaske, welche die photokatalytische dünne Filmschicht überlagert, wobei die Maske ein Maskensubstrat und ein Maskenhaftmittel umfasst, in welcher das Maskenhaftmittel in direktem Haftkontakt mit der photokatalytischen dünnen Filmschicht steht, wobei die photokatalytische dünne Filmschicht eine photokatalytische Aktivität (Standard Stearinsäuretest) von weniger als etwa 1,5 x 10⁻³ cm⁻¹min⁻¹ hat, derart, dass die photokatalytische Aktivität der photokatalytischen dünnen Filmschicht gering genug ist, dass diese die Bindung zwischen dem Maskenhaftmittel und dem Maskensubstrat oder die Bindung zwischen dem Maskenhaftmittel und der erwünschten Hauptfläche nicht zerstört.

11. Isolierglaseinheit nach Anspruch 10, in welcher das Maskenhaftmittel einen höheren Grad an Haftung an dem Maskensubstrat hat als an der beschichteten Hauptfläche, derart, dass das Haftmittel so ausgebildet ist, dass dieses vorzugsweise an dem Maskensubstrat anhaftet, wenn die Maskierung von der beschichteten Hauptfläche abgezogen wird.

12. Isolierglaseinheit nach Anspruch 10 oder 11, in welcher das Maskenhaftmittel ein Acrylhaftmittel ist und das Maskensubstrat Polyethylen umfasst.

13. Isolierglaseinheit nach Anspruch 10, 11 oder 12, in welcher das Maskenhaftmittel wenigstens einen UV-Stabilisator umfasst.

14. Isolierglaseinheit nach einem der Ansprüche 10 bis 13, in welcher das Maskenhaftmittel wenigstens ein sterisch gehindertes Amin umfasst.

15. Isolierglaseinheit nach Anspruch 14, in welcher das sterisch gehinderte Amin ein Tetramethylpiperidinderivat umfasst.

16. Isolierglaseinheit nach Anspruch 15, in welcher das sterisch gehinderte Amin ausgewählt ist aus der Gruppe bestehend aus: dem Polykondensationsprodukt von 1-(2-hydroxyethyl)-2,2,6,6-tetramethyl-4-hydroxypiperidinsuccinylsäure; dem Polykondensationsprodukt von 4,4'-hexamethylen-bis(amino-2,2,6,6-tetramethylpiperidin) und 2,4-dichloro-6-tert-octylamino-s-triazin; dem Polykondensationsprodukt von 4,4'-hexamethylen-bis(amino-2,2,6,6-tetramethylpiperidin) und 2,4-dichloro-6-cyclohexylamino-s-triazin; dem Polykondensationsprodukt von 4,4'-hexamethylen-bis(amino-2,2,6,6-tetramethylpiperidin) und 2,4-dichloro-6-morpholino-s-triazin; poly[methyl 3-(2,2,6,6-tetramethylpiperidin-4-yloxy)propyl]siloxan; bis(2,2,6,6-tetramethylpiperidin-4-yl) cyclohexylendioxydimethylmalonat; 1,355-tris{N-cyclohexyl-N-[2-(2,2,6,6-tetramethyl[rho]iperazin-3-on-4-yl)ethyl] amino-s-triazin; N,N<I>,N", N"'-tetrakis[4,6-bis(butyl-(2,2,6,6:>6-tetramethylpi[rho]eridin-4-yl)amino)-s-triazin-2-yl]-1, 10-diamino-4,7-diazadecan; und dem Polykondensationsprodukt von 2,4-dichloro-6-(2,2,6,6-tetramethylpiperidin-4-yl)butylammo-s-triazin und 2,2'ethylen-bis {[2,4-(2,2,6,6-tetramethylpiperidin-4-yl)butylamino-s-triazin-6-yl]aminotrimetylenamino}.

17. Isolierglaseinheit nach einem der Ansprüche 10 bis 16, in welcher die photokatalytische dünne Filmschicht einen aktiven Film umfasst, der Titanidin umfasst, wobei der aktive Film eine Dicke von weniger als 100 Ångström hat.

18. Isolierglaseinheit nach Anspruch 17, in welcher die Dicke des aktiven Films weniger als 75 Ångström beträgt.

19. Isolierglaseinheit nach einem der Ansprüche 10 bis 18, in welcher die photokatalytische dünne Filmschicht einen aktiven Film umfasst, der Titanidin aufweist, wobei der aktive Film direkt über einem amorphen Film abgeschieden ist.

20. Isolierglaseinheit nach Anspruch 19, in welcher die amorphe Film eine Zusammensetzung hat, die so ausgebildet ist, dass diese eine Morphologie beibehält, die wenigstens im Wesentlichen amorph ist, wenn sie einer Glasvergütung ausgesetzt wird.

21. Isolierglaseinheit nach einem der Ansprüche 10 bis 20, in welcher die photokatalytische dünne Filmschicht einen aktiven Film umfasst, der Titanidin aufweist, wobei der aktive Film direkt über einem unterlagernden Film abgeschieden wird, der eine Dicke von weniger als 200 Ångström hat.

22. Isolierglaseinheit nach Anspruch 21, in welcher die Dicke des unterlagernden Films geringer als 100 Ångström ist.

23. Isolierglaseinheit nach Anspruch 11, in welcher die Isolierglaseinheit ferner mit einer maskierten #4 Hauptfläche versehen ist, wobei die maskierte #4 Fläche eine zweite abziehbare Maske trägt.

## Revendications

1. Procédé de traitement de substrats, le procédé comprenant les opérations consistant à :
a) se procurer une première feuille de verre, ladite première feuille de verre ayant des première et deuxième surfaces majeures opposées ;
b) transporter la première feuille de verre à travers un unique appareil d'enduction par pulvérisation cathodique, et déposer par pulvérisation cathodique des revêtements sur à la fois les première et deuxième surfaces majeures en une seule passe de la première feuille de verre à travers l'appareil d'enduction par pulvérisation cathodique, ledit dépôt par pulvérisation cathodique mettant en jeu les opérations consistant à :
i) appliquer un revêtement photocatalytique sur la première surface majeure de la première feuille de verre par pulvérisation cathodique vers le haut à partir d'une première séquence de cibles, ladite première séquence de cibles comprenant une ou plusieurs cibles comprenant une matière de cible apte à subir une pulvérisation cathodique, choisie dans le groupe constitué par une matière de titane pur ou sensiblement pur, une matière d'alliage de titane, une matière d'oxyde de titane et un composé comprenant du titane et du silicium ;
ii) appliquer un revêtement à faible émissivité sur la seconde surface majeure de la première feuille de verre par pulvérisation cathodique vers le bas à partir d'une seconde séquence de cibles, ladite seconde séquence de cibles comprenant une ou plusieurs cibles comprenant une matière de cible apte à subir une pulvérisation cathodique, choisie dans le groupe constitué par une matière d'argent pur ou sensiblement pur, une matière d'alliage d'argent ;
c) adresser la première feuille de verre ainsi revêtue à une chaîne de montage d'unités de vitrages isolants à parois multiples ;
d) transporter la première feuille de verre ainsi revêtue le long de la chaîne de montage et assembler une telle première feuille de verre avec une seconde feuille de verre, de telle sorte que l'assemblage de verre isolant résultant délimite un intervalle entre lesdites première et seconde feuilles de verre et que la première surface majeure revêtue de ladite première feuille de verre est une surface extérieure orientée à l'opposé dudit intervalle ;
e) appliquer un premier masquage pelable sur le revêtement photocatalytique, ledit premier masquage comprenant un substrat de masquage et un adhésif de masquage, ladite application du premier masquage sur le revêtement photocatalytique mettant en jeu l'adhésion de l'adhésif de masquage directement sur le revêtement photocatalytique, le revêtement photocatalytique ayant une activité photocatalytique (test à l'acide stéarique standard) de moins d'environ 1,5 x 10⁻³cm⁻¹min⁻¹, de telle sorte que l'activité photocatalytique du revêtement photocatalytique est suffisamment faible pour ne pas détruire la liaison entre l'adhésif de masquage et le substrat de masquage ou la liaison entre l'adhésif de masquage et ladite première surface majeure.

2. Procédé selon la revendication 1, dans lequel le revêtement photocatalytique comprend un film actif comprenant de l'oxyde de titane, ledit film actif étant déposé par pulvérisation cathodique à une épaisseur de moins de 100 angströms.

3. Procédé selon l'une des revendications 1 ou 2, dans lequel le revêtement photocatalytique comprend un film actif comprenant de l'oxyde de titane, le film actif étant déposé par pulvérisation cathodique directement sur un film amorphe.

4. Procédé selon l'une quelconque des revendications précédentes, dans lequel ladite application du premier masquage sur le revêtement photocatalytique met en jeu l'actionnement d'une première station de masquage, ladite première station de masquage faisant partie de ladite chaîne de montage.

5. Procédé selon l'une quelconque des revendications précédentes, comprenant l'application d'un second masquage pelable sur une surface #4 dudit assemblage de verre isolant résultant par actionnement d'une seconde station de masquage, ladite seconde station de masquage faisant également partie de ladite chaîne de montage.

6. Procédé selon l'une quelconque des revendications précédentes, dans lequel ledit adhésif de masquage appliqué a un niveau d'adhésion au substrat de masquage supérieur à celui au revêtement photocatalytique.

7. Procédé selon la revendication 6, comprenant en outre le retrait par pelage du premier masquage de la surface majeure portant le revêtement photocatalytique, retrait par pelage pendant lequel l'adhésif adhère de façon préférentielle au substrat de masquage de telle sorte que sensiblement la totalité de l'adhésif reste sur le substrat de masquage du premier masquage une fois que le premier masquage a été retiré par pelage de la surface majeure portant le revêtement photocatalytique.

8. Procédé selon l'une quelconque des revendications précédentes, dans lequel l'adhésif de masquage est un adhésif acrylique et le substrat de masquage comprend du polyéthylène.

9. Procédé selon l'une quelconque des revendications précédentes, dans lequel l'adhésif de masquage comprend au moins un stabilisant vis-à-vis du rayonnement UV.

10. Unité de vitrage isolant comprenant une première paroi et une deuxième paroi, lesdites deux parois étant espacées l'une de l'autre avec un intervalle entre elles ; un revêtement à faible émissivité sur une surface majeure d'au moins la première paroi, ladite surface majeure étant une surface intérieure tournée vers ledit intervalle ; un revêtement de film mince photocatalytique sur une surface majeure désirée de la première paroi, ladite surface majeure désirée étant une surface extérieure tournée à l'opposé dudit intervalle ; et un masquage protecteur pelable recouvrant le revêtement de film mince photocatalytique, ledit masquage comprenant un substrat de masquage et un adhésif de masquage, l'adhésif de masquage étant en contact adhésif direct avec le revêtement de film mince photocatalytique, le revêtement de film mince photocatalytique ayant une activité photocatalytique (essai à l'acide stéarique standard) de moins d'environ 1,5 x 10⁻³ cm⁻¹min⁻¹, de telle sorte que l'activité photocatalytique du revêtement de film mince photocatalytique est suffisamment faible pour ne pas détruire la liaison entre l'adhésif de masquage et le substrat de masquage ou la liaison entre l'adhésif de masquage et ladite surface majeure désirée.

11. Unité de vitrage isolant selon la revendication 10, dans laquelle l'adhésif de masquage a un niveau d'adhésion au substrat de masquage supérieur à celui à ladite surface majeure revêtue, de telle sorte que l'adhésif est adapté pour adhérer de façon préférentielle au substrat de masquage lorsque le masquage est retiré par pelage de ladite surface majeure revêtue.

12. Unité de vitrage isolant selon l'une des revendications 10 ou 11, dans laquelle l'adhésif de masquage est un adhésif acrylique et le substrat de masquage comprend du polyéthylène.

13. Unité de vitrage isolant selon l'une des revendications 10, 11 ou 12, dans laquelle l'adhésif de masquage comprend au moins un stabilisant vis-à-vis du rayonnement UV.

14. Unité de vitrage isolant selon l'une quelconque des revendications 10 à 13, dans laquelle l'adhésif de masquage comprend au moins une amine encombrée.

15. Unité de vitrage isolant selon la revendication 14, dans laquelle l'amine encombrée comprend un dérivé de tétraméthyl pipéridine.

16. Unité de vitrage isolant selon la revendication 15, dans laquelle l'amine encombrée est choisie dans le groupe constitué par : le produit de polycondensation de la 1-(2-hydroxyéthyl)-2,2,6,6-tétraméthyl-4-hydroxypipéridine et de l'acide succinique ; le produit de polycondensation de la 4,4'-hexaméthylène-bis(amino-2,2,6,6-tétraméthylpipéridine) et de la 2,4-dichloro-6-tert-octylamino-s-triazine ; le produit de polycondensation de la 4,4'-hexaméthylène-bis(amino-2,2,6,6-tétraméthylpipéridine) et de la 2,4-dichloro-6-cyclohexylamino-s-triazine ; le produit de condensation de la 4,4'-hexaméthylène-bis(amino-2,2,6,6-tétraméthylpipéridine) et de la 2,4-dichloro-6-morpholino-s-triazine ; le poly[méthyl-3-(2,2,6,6-tétraméthylpipéridin-4-yloxy)propyl]siloxane ; le bis(2,2,6,6-tétraméthylpipéridin-4-yl)cyclohexylènedioxydiméthylmalonate ; la 1,3,5-tris{N-cyclohexyl-N-[2-(2,2,6,6-tétraméthylpipérazin-3-on-4-yl)éthyl]amino-s-triazine ; le N,N',N",N"'-tétrakis[4,6-bis(butyl-(2,2,6,6-tétraméthylpipéridin-4-yl)amino)-s-triazin-2-yl]-1,10-diamino-4,7-diazadécane ; et le produit de polycondensation de la 2,4-dichloro-6-(2,2,6,6-tétraméthylpipéridin-4-yl)butylamino-s-triazine et du 2,2'-éthylène-bis{[2,4-(2,2,6,6-tétraméthylpipéridin-4-yl)butylamino-s-triazin-6-yl]aminotriméthylèneamino}.

17. Unité de vitrage isolant selon l'une quelconque des revendications 10 à 16, dans laquelle le revêtement de film mince photocatalytique comprend un film actif comprenant de l'oxyde de titane, ledit film actif ayant une épaisseur de moins de 100 angströms.

18. Unité de vitrage isolant selon la revendication 17, dans laquelle l'épaisseur du film actif est inférieure à 75 angströms.

19. Unité de vitrage isolant selon l'une quelconque des revendications 10 à 18, dans laquelle le revêtement de film mince photocatalytique comprend un film actif comprenant de l'oxyde de titane, le film actif étant déposé directement sur un film amorphe.

20. Unité de vitrage isolant selon la revendication 19, dans laquelle le film amorphe a une composition apte à maintenir une morphologie qui est au moins sensiblement amorphe lorsqu'il est soumis à un trempage au verre.

21. Unité de vitrage isolant selon l'une quelconque des revendications 10 à 20, dans laquelle le revêtement de film mince photocatalytique comprend un film actif comprenant de l'oxyde de titane, le film actif étant déposé directement sur un film sous-jacent ayant une épaisseur de moins de 200 angströms.

22. Unité de vitrage isolant selon la revendication 21, dans laquelle l'épaisseur du film sous-jacent est inférieure à 100 angströms.

23. Unité de vitrage isolant selon la revendication 11, dans laquelle l'unité de vitrage isolant est encore dotée d'une surface majeure #4 masquée, la surface majeure #4 masquée portant un second masquage pelable.
